# EUROPEAN PATENT SPECIFICATION

(11) **EP 2 451 257 B1**
(45) Date of publication and mention of the grant of the patent: **20.07.2016**
(21) Application number: 11187909.4
(22) Date of filing: 04.11.2011
(51) Int. Cl.: H05K 3/34, H01R 4/02, H01R 12/58, H01R 12/72

(54) **Circuit board assembly, connector, and soldering method therefor**
Schalttafelanordnung, Stecker und Schweißverfahren dafür
Ensemble formant carte de circuit, connecteur et procédé de soudure correspondant

(30) Priority: 05.11.2010 JP 2010248539
(43) Date of publication of application: 09.05.2012
(73) Proprietor: Tyco Electronics Japan G.K., Takatsu-ku Kawasaki Kanagawa 213-8535 (JP)
(72) Inventor: Hayashi, Toshiaki, Kawasaki, Kanagawa 213-8535 (JP)
(74) Representative: Klunker . Schmitt-Nilson . Hirsch

(56) References cited:
- JP-A- H0 278 172
- JP-A- H1 154 907
- JP-A- H06 169 152
- US-A- 5 184 283

## Description

### BACKGROUND OF THE INVENTION

### Field of the Invention

The present invention relates to a circuit board assembly provided with a connector overhanging from a circuit board to the outer periphery side, such a connector, and a soldering method therefor.

### Description of the Related Art

It is well known that in the case where wiring is connected to a circuit board, which is used for various control devices, from the outside, a board-side connector provided on the circuit board and a wiring-side connector provided on the wiring side are engaged with each other.

Such a board-side connector has a housing, and a plurality of terminals held on the housing. One end of each of the terminals is inserted into a through hole formed in the circuit board, and the terminal and a conductive pattern provided around the through hole are soldered to each other, whereby the board-side connector is electrically connected to the circuit board.

Some arrangement of control device is such that, because of wiring layout, the wiring-side connector is inserted into and pulled out of the board-side connector along the direction parallel with the surface of the circuit board. In this case, from the viewpoint of workability and the like at the time when the wiring-side connector is inserted and pulled out, the board-side connector is provided in the outer peripheral portion of the circuit board, and the wiring-side connector is inserted into and pulled out of the board-side connector from the outer periphery side of the circuit board.

For some board-side connectors arranged as described above, to effectively utilize the area on the circuit board, only a part of the housing is supported by the outer peripheral portion of the circuit board, and the remaining part of the housing overhangs to the outer periphery side of the circuit board (for example, refer to Japanese Patent Laid-Open No. 2008-47432).

However, the configuration described in Japanese Patent Laid-Open No. 2008-47432 has a problem of how the board-side connector (housing) is fixed in the process in which one end of the terminal is soldered to the circuit board. In the case where one end of the terminal is merely inserted into the through hole of the circuit board, since the housing overhangs to the outer periphery side of the circuit board, the board-side connector may be highly likely to fall off the circuit board due to its center of gravity. Also, even if not fall off, if the board-side connector is subjected to the soldering process while the connector is inclined, all of the terminals may not be properly soldered to the circuit board in some cases, which exerts an adverse influence on the quality.

Accordingly, in Japanese Patent Laid-Open No. 2007-329049, the housing is fixed to the circuit board by fastening means such as bolts. In such a configuration, however, before the soldering process, the housing must be fixed to the circuit board by the fastening means, which takes much time and labor and hinders the improvement in production efficiency. Also, a space for fastening the housing with bolts or the like is necessary, and the effective utilization of the area on the circuit board is hindered.

To enable a printed wiring board to be improved in quality preventing flux from penetrating into a connector contact and lessened in number of soldering processes by joining a connector to the front end of the printed wiring board when the connector is mounted on and soldered to the end of the printed wiring board, JP H06 1691 152 A (of the preamble of claim 1) discloses a printed wiring board structure in which a dummy board is provided to the end of a printed wiring board, and a V-shaped groove, which serves both to cut the dummy board off from the printed wiring board and as a relief of a reinforcing part of a connector mounted on the printed wiring board, is provided to a boundary between the dummy board and the printed wiring board. Thereby flux is prevented from creeping up to the connector when flux is applied, and also solder is prevented from creeping up to the connector when a soldering operation is carried out, but also the dummy board is removed by cutting it along the V-shaped groove.

To permit highly reliable soldering joint in a simple way by soaking the connecting pattern of a terminater card and respective leads of a connector which are retained by a positioning jig in melted solder for soldering, JP H02 78172 A discloses a terminater card and soldering method in which a groove in an insulator of a connector is engaged with a locking portion installed on a side wall of a positioning jig and a reference hole in a terminater card is fitted into the protrusion on a supporting face, so that the locations of a lead of the connector and a connecting pattern of the card are automatically agreed. When these are soaked in welded solder in a solder bath at a preset temperature and soldered, the attachment amount of a solder is minimized as required to prevent the occurrence of soldering bridges between adjacent patterns.

According to US 5 184 283 A a power device assembly comprises a circuit board sub-assembly and a protective housing enclosing the circuit board sub-assembly. The circuit board sub-assembly includes a heat sink frame around the periphery of a circuit board. Heat generating power devices and, optionally, other circuit devices are mounted in thermally conductive contact with the heat sink frame. Electrical leads extend from the power devices to the circuit board where a solder connection is formed. The heat sink frame extends outwardly beyond the circuit board, at least a portion extending outwardly from the protective housing to provide cooling means for the assembly.

### SUMMARY OF THE INVENTION

The present invention has been accomplished in view of the above-described problems, and accordingly an object thereof is to provide a circuit board assembly capable of supporting a board-side connector in the soldering process and capable of reliably soldering the board-side connector to a circuit board to achieve efficient production, and to provide a connector and a soldering method therefor.

To achieve the above object, the present invention includes a circuit board; and a connector to which a mating connector provided at one end of an external wiring harness is connected in order to connect a circuit pattern of the circuit board to the wiring harness, wherein the connector includes a plurality of contacts one end of each of which is electrically connected to the circuit pattern of the circuit board, and the other end of each of which is electrically connected to a mating contact of the mating connector; and a housing for holding the contacts. The housing is provided so as to overhang toward the outer periphery side of the circuit board, and in a portion overhanging toward the outer periphery side from the circuit board, the housing comprises a protruding part projecting toward the direction orthogonally intersecting the overhanging direction and along the surface of the circuit board.

Such a protruding part is used to hold the housing while the one end of the contact is inserted into a through hole formed in the circuit board and is soldered to the circuit pattern of the circuit board. Thereby, the positional relationship between the housing and the circuit board can be maintained stably in the soldering process.

Therefore, the protruding part is preferably provided in the vicinity of the gravity center position of the connector in the overhanging direction.

The soldering may be performed by using either a flow-type soldering device or a reflow-type soldering device. In the case where the reflow-type soldering device is used, to support the circuit board and the connector on support rails, the lower surface of the protruding part is preferably provided so as to be located in almost the same plane as the soldering surface of the circuit board.

The protruding part may be provided at any position. However, to support the housing stably, the protruding part is preferably provided at least on both sides of the housing.

Also, the present invention provides a connector provided so as to overhang from the outer peripheral portion of a circuit board, wherein the connector includes contacts electrically connected to circuit patterns of the circuit board; and a housing for holding the contacts, the housing comprises a holding protrusion, which is used to hold the housing while one end of each of the contacts is soldered to the circuit pattern of the circuit board, in a portion overhanging toward the outer periphery side from the circuit board.

Further, the present invention provides a soldering method for a connector as described above and a circuit board, including the steps of temporarily assembling a housing which holds contacts to be electrically connected to circuit patterns of the circuit board to the outer peripheral portion of the circuit board in a state in which the housing overhangs to the outer periphery side from the circuit board, and supporting a holding protrusion formed on the housing and the circuit board on a support member of a soldering device; and soldering one end of the contact to a wiring pattern of the circuit board supported on the support member.

According to the present invention, while the one end of the contact is soldered to the circuit pattern of the circuit board, the positional relationship between the housing and the circuit board can be maintained stably by the protruding part or the holding protrusion. Thereby, the connector can be soldered to the circuit board reliably. Also, the protruding part or the holding protrusion of the housing has only to be placed on the support rails or the like. Therefore, much time and labor are not required, and efficient production can be achieved.

### BRIEF DESCRIPTION OF THE DRAWINGS

FIG. 1 is a perspective view of a circuit board assembly in accordance with an embodiment of the present invention;
FIG. 2 is a side sectional view of the circuit board assembly shown in FIG. 1;
FIG. 3 is a plan view of the circuit board assembly shown in FIG. 1; and
FIG. 4 is a perspective view of an electrical connector viewed from the side of being installed to a board.

### DETAILED DESCRIPTION OF THE PREFERRED EMBODIMENT

The present invention will now be described in detail based on an embodiment shown in the accompanying drawings.

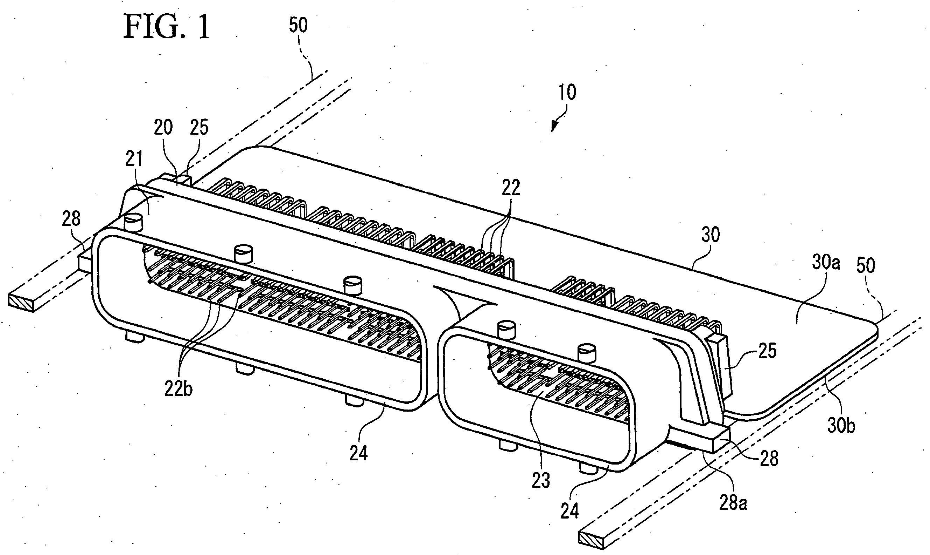

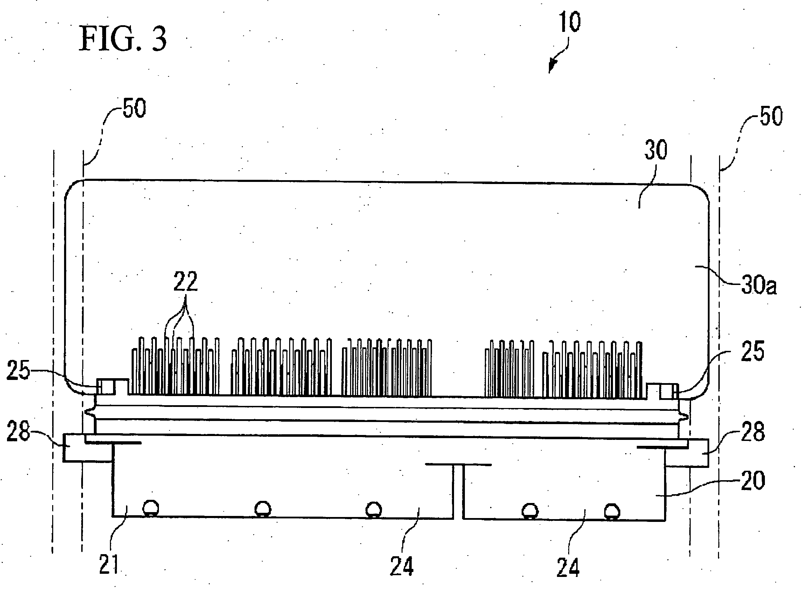

As shown in FIGS. 1 to 3, an electronic control device 10 includes a circuit board assembly comprising an electrical connector 20 and a circuit board 30.

The circuit board 30 is mounted with various electronic components, and functions as a control circuit for executing predetermined operations as an electronic control device.

The electrical connector 20 is used to supply a power to the circuit board 30 from the outside and to input and output electrical signals. Specifically, to the electrical connector 20, a mating connector provided at one end of a wiring harness is connected from the outside.

The electrical connector 20 includes a resin-made housing 21 and a plurality of contacts 22 each made of a conductive material.

The housing 21 is provided in the outer peripheral end portion of the circuit board 30. In the housing 21, a plate-shaped contact holding plate part 23 having holding holes for holding the plurality of contacts 22 is formed so as to be located in a plane orthogonally intersecting the surface of the circuit board 30.

Each of the contacts 22 is pressed in the holding hole so as to penetrate the contact holding plate part 23 from one side to the other side. The contact 22 is bent through 90 degrees with respect to the contact holding plate part 23 on the circuit board 30 side, and one end 22a thereof is inserted into a through hole 31 formed in the circuit board 30. The one end 22a of the contact 22 is electrically connected, by soldering, to a conductive pattern formed on the inner peripheral face of the through hole 31 and around the circumference thereof.

Each of the contact 22 is formed so that the other end 22b thereof extends from the contact holding plate part 23 toward the outer periphery side of the circuit board 30 in the direction along the surface of the circuit board 30.

The housing 21 comprises a tubular hood part 24 extending from the contact holding plate part 23 to the side on which the other ends 22b of the contacts 22 are located. The other ends 22b of the contacts 22 are surrounded by this hood part 24. In this embodiment, two hood parts 24 having different sizes are provided.

Into the hood part 24, a mating connector (male connector, not shown), which is provided at the tip end of a wiring harness, not shown, connected to an electronic control device is inserted, and, in the hood part 24, a mating contact (female contact, not shown) held to the mating connector of a wiring cord engages with the other end 22b of the contact 22, whereby electrical connection is made.

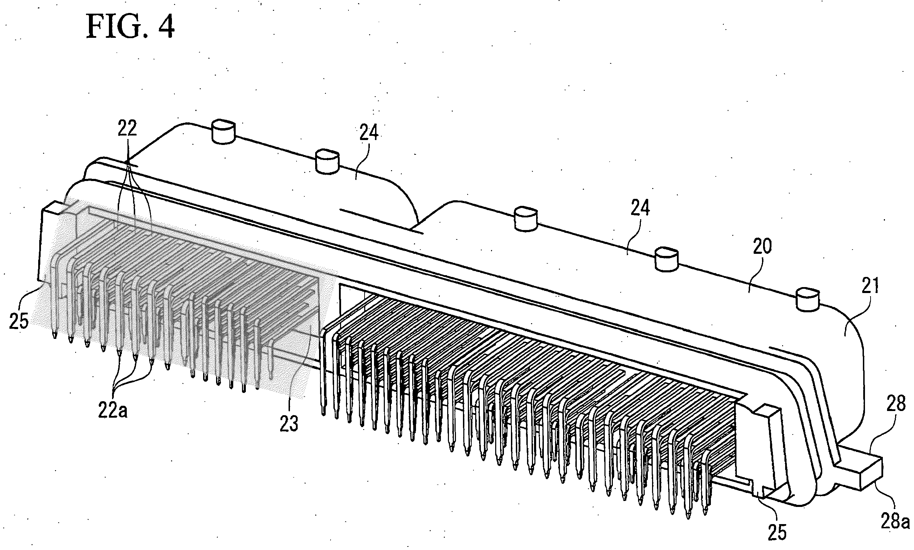

As shown in FIG. 4, the contact holding plate part 23 comprises, integrally formed stopper parts 25, which abut a mounting surface 30a of the circuit board 30, on the circuit board 30 side. The stopper parts 25 are provided on both ends in the width direction (the direction along the surface of the circuit board 30). By the stopper parts 25, the dimension of insertion of the one end 22a of the contact 22 into the through hole 31 can be regulated.

Also, on the housing 21, support parts (protruding parts, holding protrusions) 28 projecting toward the outside in the width direction are formed on both ends in the width direction of the housing 21.

Each of the support parts 28 is formed so that, in the state in which the mounting surface 30a of the circuit board 30 abuts the tip end surfaces of the stopper parts 25, a tip end surface (lower surface) 28a of the support part 28 is located in the same plane as a soldering surface 30b of the circuit board 30.

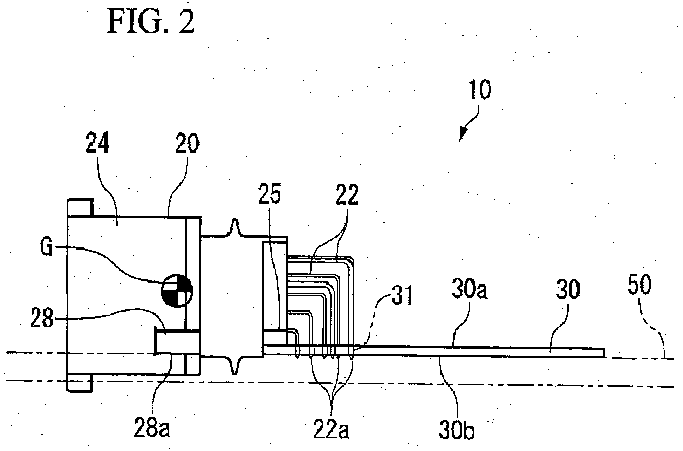

As shown in FIG. 2, it is preferable that the support parts 28 be provided at positions in conformity to the gravity center position G of the electrical connector 20 in the direction along the extending direction of the other ends 22b of the contacts 22.

Also, the support part 28 may be provided in plural numbers at intervals on both ends in the width direction of the housing 21 in the direction along the extending direction of the other ends 22b of the contacts 22.

In order to mount the above-described electrical connector 20 to the outer peripheral portion of the circuit board 30, first, the electrical connector 20 is temporarily assembled to the circuit board 30. The temporary assembling is performed as described below. The ends 22a of the contacts 22 in the electrical connector 20 are inserted into the through holes 31 of the circuit board 30, and the stopper parts 25 are abutted against the mounting surface 30a of the circuit board 30.

Next, in this state, the ends 22a of the contacts 22 are soldered to the conductive patterns of the circuit board 30 by using a soldering device.

At this time, as the soldering device, a reflow-type device is used.

The soldering device comprises support rails (support members) 50 for moving the board to be soldered while supporting it above a solder tank. Both the ends of the circuit board 30 and the support parts 28 on both sides are located on these support rails 50.

The circuit board 30 to which the electrical connector 20 has been temporarily assembled is placed on the support rails 50, and is exposed to warm air while being moved along the support rails 50. Thereby, solder paste having been applied in advance to the circuit board 30 is melted, and resultantly the ends 22a of the contacts 22 having been inserted into the through holes 31 are soldered to the wiring patterns of the Circuit board 30.

When the circuit board 30 is carried while being supported by the support rails 50 as described above, since the support parts 28 on both ends of the electrical connector 20 are located on the support rails 50, the electrical connector 20 is supported by the support rails 50. Thereby, the positional relationship between the electrical connector 20 and the circuit board 30 can be maintained, and in the soldering process, the electrical connector 20 can be prevented from falling off the circuit board 30. Therefore, the ends 22a of the contacts 22 can be soldered reliably to the wiring patterns of the circuit board 30 so that high quality is maintained.

Also, a fastening means such as bolts or the like need not be used, and soldering can be performed reliably, so that the time and labor can be reduced, and the production efficiency can be improved. Also, a space for fastening the bolts or the like is not needed, so that the area on the circuit board 30 can be utilized effectively.

Further, the support parts 28 are provided at positions in conformity to the gravity center position G of the electrical connector 20 in the direction along the extending direction of the other ends 22b of the contacts 22, so that the contacts 22 themselves can be carried stably.

In the above-described embodiment, a reflow-type soldering device is used. However, in place of the reflow type, a flow-type soldering device can also be used. In this case, both the ends of the circuit board 30 and the support parts 28 on both sides are located on jigs (support members). The jigs are moved along the upper part of the solder tank. Then, sprayed solder in the solder tank comes into contact with the soldering surface 30b of the circuit board 30, and the ends 22a of the contacts 22 inserted into the through holes 31 are soldered to the wiring patterns of the circuit board 30.

Also, in the case of the flow type, the tip end surface 28a of the support part 28 need not necessarily be formed in almost the same plane as the soldering surface 30b of the circuit board 30. The tip end surface 28a has only to be formed at a height and position corresponding to a holding part formed on the jig side.

Although the support part 28 is provided on both sides of the housing 21, the support part 28 can be provided at positions other than the above-described positions. For example, the support part 28 can be provided at positions between the contacts 22 arranged in plural numbers, that is, in intermediate portions or the like in the width direction of the housing 21.

Further, in the above-described embodiment, the housing 21 comprises the stopper parts 25, and these stopper parts 25 abut the mounting surface 30a of the circuit board 30. However, the stopper parts 25 are not essential elements. The portions of the electrical connector 20 including the housing 21 other than the ends 22a of the contacts 22 may not be in contact with the circuit board 30 while the ends 22a of the contacts 22 are inserted into the through holes 31 of the circuit board 30. In this case as well, in the soldering process, since the support parts 28 are supported on the soldering device side, soldering can be performed while the electrical connector 20 is held stably.

In such a case, a space for abutting the stopper parts 25 against the mounting surface 30a of the circuit board 30 is not needed, so that the area on the circuit board 30 can be utilized further effectively.

Besides, the configurations described in the above-described embodiment can be selected, or can be changed to other configurations as appropriate within the scope of the claims.

## Claims

1. A circuit board assembly comprising:
a circuit board (30) comprising a mounting surface (30a) and an opposing soldering surface (30b); and
a connector (20) comprising:
contacts (22) electrically connected to circuit patterns of the circuit board (30); and
a housing (21) for holding the contacts, wherein the housing comprises, in a portion overhanging toward the outer periphery side from the circuit board,
a holding protrusion (28), which is used to hold the housing while one end (22a) of each of the contacts is soldered to the circuit pattern of the circuit board,
to which a mating connector provided at one end of an external wiring harness is connected in order to connect a circuit pattern of the circuit board (30) to the wiring harness,
wherein the one end (22a) of each of the contacts (22) is electrically connected to the circuit pattern of the circuit board, and the other end (22b) of each of the contacts (22) is configured for being electrically connected to a mating contact of the mating connector;
wherein in the portion overhanging toward the outer periphery side from the circuit board, the housing comprises a holding protrusion (28) projecting toward the direction orthogonally intersecting the overhanging direction and along the surface of the circuit board;
**characterized in that** the lower surface of the holding protrusion (28) is provided so as to be located in almost the same plane as the soldering surface (30b) of the circuit board (30).

2. The circuit board assembly according to claim 1, wherein the holding protrusion (28) is used to hold the housing (21) while the one end (22a) of the contact is inserted into a through hole (31) formed in the circuit board (30) and is soldered to the circuit pattern of the circuit board.

3. The circuit board assembly according to claim 1 or 2, wherein the holding protrusion (28) is provided in the vicinity of the gravity center position (G) of the connector in the overhanging direction.

4. The circuit board assembly according to any one of claims 1 to 3, wherein the holding protrusion (28) is provided on both sides of the housing (21).

5. A soldering method for producing a circuit board assembly according to one of the preceding claims comprising the steps of:
providing a circuit board (30) comprising a mounting surface (30a) and an opposing soldering surface (30b) and a connector (20) comprising:
contacts (22) electrically connected to circuit patterns of the circuit board (30); and
a housing (21) for holding the contacts, wherein the housing comprises, in a portion overhanging toward the outer periphery side from the circuit board,
a holding protrusion (28), which is used to hold the housing while one end (22a) of each of the contacts is soldered to the circuit pattern of the circuit board,
temporarily assembling the housing (21) which holds contacts (22) to be electrically connected to circuit patterns of the circuit board (30) to the outer peripheral portion of the circuit board (30) in a state in which the housing (21) overhangs to the outer periphery side from the circuit board (30), and supporting the holding protrusion (28) formed on the housing (21) and the circuit board (30) on a support member (50) of a soldering device such that the lower surface of the holding protrusion (28) is provided so as to be located in almost the same plane as the soldering surface (30b) of the circuit board (30); and
soldering one end (22a) of the contact to a wiring pattern of the circuit board (30) supported on the support member (50).

6. The soldering method according to claim 5, wherein the soldering is performed by using a reflow-type soldering device.

## Patentansprüche

1. Leiterplattenbaugruppe, die Folgendes umfasst:
eine Leiterplatte (30), die eine Montagefläche (30a) und eine gegenüberliegende Lötfläche (30b) umfasst, und
einen Steckverbinder (20), der Folgendes umfasst:
Kontakte (22), die elektrisch mit Schaltkreismustern der Leiterplatte (30) verbunden sind, und
ein Gehäuse (21) zum Aufnehmen der Kontakte, wobei das Gehäuse, in einem Abschnitt, der von der Leiterplatte zur Außenumfangsseite hin überhängt,
einen Haltevorsprung (28) umfasst, der dazu verwendet wird, das Gehäuse zu halten, während ein Ende (22a) jedes der Kontakte an das Schaltkreismuster der Leiterplatte gelötet wird,
mit dem ein Gegensteckverbinder, der an einem Ende eines externen Kabelbaums bereitgestellt wird, verbunden ist, um ein Schaltkreismuster der Leiterplatte (30) mit dem Kabelbaum zu verbinden,
wobei das eine Ende (22a) jedes der Kontakte (22) elektrisch mit dem Schaltkreismuster der Leiterplatte verbunden ist und das andere Ende (22b) jedes der Kontakte (22) dazu dient, elektrisch mit einem Gegenkontakt des Gegensteckverbinders verbunden zu werden,
wobei das Gehäuse, in dem Abschnitt, der von der Leiterplatte zur Außenumfangsseite hin überhängt, den Haltevorsprung (28) umfasst, der zu der Richtung, welche die Überhangrichtung senkrecht schneidet, hin und entlang der Fläche der Leiterplatte vorspringt,
**dadurch gekennzeichnet, dass** die untere Fläche des Haltevorsprungs (28) so bereitgestellt wird, dass sie in nahezu der gleichen Ebene angeordnet ist wie die Lötfläche (30b) der Leiterplatte (30).

2. Leiterplattenbaugruppe nach Anspruch 1, wobei der Haltevorsprung (28) dazu verwendet wird, das Gehäuse (21) zu halten, während das eine Ende (22a) des Kontakts in ein Durchgangsloch (31) eingesetzt wird, das in der Leiterplatte (30) geformt ist, und an das Schaltkreismuster der Leiterplatte gelötet wird.

3. Leiterplattenbaugruppe nach Anspruch 1 oder 2, wobei der Haltevorsprung (28) in der Nähe der Schwerpunktposition (G) des Steckverbinders in der Überhangrichtung bereitgestellt wird.

4. Leiterplattenbaugruppe nach einem der Ansprüche 1 bis 3, wobei der Haltevorsprung (28) auf beiden Seiten des Gehäuses (21) bereitgestellt wird.

5. Lötverfahren zum Herstellen einer Leiterplattenbaugruppe nach einem der vorhergehenden Ansprüche, das die folgenden Schritte umfasst:
das Bereitstellen einer Leiterplatte (30), die eine Montagefläche (30a) und eine gegenüberliegende Lötfläche (30b) umfasst, und eines Steckverbinders (20), der Folgendes umfasst:
Kontakte (22), die elektrisch mit Schaltkreismustern der Leiterplatte (30) verbunden sind, und
ein Gehäuse (21) zum Aufnehmen der Kontakte, wobei das Gehäuse, in einem Abschnitt, der von der Leiterplatte zur Außenumfangsseite hin überhängt,
einen Haltevorsprung (28) umfasst, der dazu verwendet wird, das Gehäuse zu halten, während ein Ende (22a) jedes der Kontakte an das Schaltkreismuster der Leiterplatte gelötet wird,
das zeitweilige Zusammenbauen des Gehäuses (21), das Kontakte (22) aufnimmt, die elektrisch mit Schaltkreismustern der Leiterplatte (30) verbunden werden sollen, mit dem Außenumfangsabschnitt der Leiterplatte (30) in einen Zustand in dem das Gehäuse (21) von der Leiterplatte (30) zur Außenumfangsseiten hin überhängt und das Stützen des Haltevorsprungs (28), der an dem Gehäuse (21) geformt ist, und der Leiterplatte (30) auf einem Stützelement (50) einer Lötvorrichtung, derart, dass die untere Fläche des Haltevorsprungs (28) so bereitgestellt wird, dass sie in nahezu der gleichen Ebene angeordnet ist wie die Lötfläche (30b) der Leiterplatte (30), und
das Löten eines Endes (22a) des Kontakts an ein Verdrahtungsmuster der Leiterplatte (30), die auf dem Stützelement (50) gestützt wird.

6. Lötverfahren nach Anspruch 5, wobei das Löten durch die Verwendung einer Aufschmelz-Lötvorrichtung ausgeführt wird.

## Revendications

1. Assemblage de carte de circuit imprimé, comprenant :
une carte de circuit imprimé (30), comprenant une surface de montage (30a) et une surface de soudage opposée (30b) ; et
un connecteur (20), comprenant :
des contacts (22) connectés électriquement à des pistes de circuit de la carte de circuit imprimé (30) ; et
un boîtier (21) pour retenir les contacts, le boîtier comprenant, dans une partie débordant vers le côté périphérique externe de la carte de circuit imprimé :
une saillie de retenue (28) servant à retenir le boîtier pendant qu'une extrémité (22a) de chacun des contacts est soudée sur la piste de circuit de la carte de circuit imprimé ;
auquel est connecté un connecteur d'accouplement, agencé au niveau d'une extrémité d'un faisceau de câblage externe en vue de connecter une piste de circuit de la carte de circuit imprimé (30) au faisceau de câblage ;
dans lequel ladite une extrémité (22a) de chacun des contacts (22) est connectée électriquement à la piste de circuit de la carte de circuit imprimé, l'autre extrémité (22b) de chacun des contacts (22) servant à être connectée électriquement à un contact d'accouplement du connecteur d'accouplement ;
dans lequel, dans la partie débordant vers le côté périphérique externe de la carte de circuit imprimé, le boîtier comprend la saillie de retenue (28) débordant vers la direction coupant de manière orthogonale la direction en surplomb et le long de la surface de la carte de circuit imprimé ;
**caractérisé en ce que** la surface inférieure de la saillie de retenue (28) est agencée de sorte à être positionnée dans pratiquement le même plan que la surface de soudage (30b) de la carte de circuit imprimé (30).

2. Assemblage de carte de circuit imprimé selon la revendication 1, dans lequel la saillie de retenue (28) sert à retenir le boîtier (21) pendant que ladite une extrémité (22a) du contact est insérée dans un trou de passage (31) formé dans la carte de circuit imprimé (30) et est soudée sur la piste de circuit de la carte de circuit imprimé.

3. Assemblage de carte de circuit imprimé selon la revendication 1 ou 2, dans lequel la saillie de retenue (28) est agencée au voisinage de la position du centre de gravité (G) du connecteur dans la direction en surplomb.

4. Assemblage de carte de circuit intégré selon l'une quelconque des revendications 1 à 3, dans lequel la saillie de retenue (28) est agencée sur les deux côtés du boîtier (21).

5. Procédé de soudage pour produire un assemblage de carte de circuit imprimé selon l'une des revendications précédentes, englobant les étapes ci-dessous :
fourniture d'une carte de circuit imprimé (30), comprenant une surface de montage (30a) et une surface de soudage opposée (30b), et un connecteur (20) comprenant :
des contacts (22) connectés électriquement à des pistes de circuit de la carte de circuit imprimé (30) ; et
un boîtier (21) pour retenir les contacts, dans lequel le boîtier comprend, dans une partie débordant vers le côté périphérique externe de la carte de circuit imprimé :
une saillie de retenue (28) servant à retenir le boîtier pendant qu'une extrémité (22a) de chacun des contacts est soudée sur la piste de circuit de la carte de circuit imprimé ;
assemblage temporaire du boîtier (21) retenant les contacts (22) en vue de la connexion électrique à des pistes de circuit de la carte de circuit imprimé (30), vers la partie périphérique externe de la carte de circuit imprimé (30), dans un état dans lequel le boîtier (21) déborde vers le côté périphérique externe de la carte de circuit imprimé (30), et support de la saillie de retenue (28) formée sur le boîtier (21) et de la carte de circuit imprimé (30) sur un élément de support (50) d'un dispositif de soudage, de sorte que la surface inférieure de la saillie de retenue (28) est agencée de sorte à être positionnée dans pratiquement le même plan que la surface de soudage (30b) de la carte de circuit imprimé (30) ; et
soudage d'une extrémité (22a) du contact sur un faisceau de câblage de la carte de circuit imprimé (30) supporté sur l'élément de support (50).

6. Procédé de soudage selon la revendication 5, dans lequel le soudage est effectué en utilisant un dispositif de soudage du type par refusion.
